(19) Europäisches Patentamt / European Patent Office / Office européen des brevets

(11) **EP 2 481 556 A1**

(12) **EUROPEAN PATENT APPLICATION**

(43) Date of publication:
**01.08.2012 Bulletin 2012/31**

(21) Application number: **11188733.7**

(22) Date of filing: **11.11.2011**

(51) Int Cl.:
*B29C 70/22* (2006.01)   *B29C 70/78* (2006.01)
*B29K 105/08* (2006.01)   *B29K 311/10* (2006.01)
*B29K 267/00* (2006.01)   *B29K 701/12* (2006.01)
*B29D 99/00* (2010.01)   *G06F 1/16* (2006.01)
*G06F 1/18* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.01.2011 JP 2011018669**

(71) Applicant: **Hishida, Iwao**
**Toyonaka-shi Osaka (JP)**

(72) Inventor: **Hishida, Iwao**
**Toyonaka-shi Osaka (JP)**

(74) Representative: **Vossius & Partner**
**Siebertstrasse 4**
**81675 München (DE)**

(54) **Casing for electronic device, method for manufacturing same, and electronic device**

(57)    There are provided a casing for an electronic device and an electronic device, which are free from undesirable sticking of dust due to static electricity in a plastic electronic device as well as malfunctions and failures of a built-in device such as a computer; have improved weatherability, impact resistance, and vibration-damping property; and are superior in design properties.

A casing for various types of electronic devices, such as compact electronic devices, e.g., a mobile terminal (portable telephone etc.), portable gaming terminal, and portable player; a personal computer (main unit and monitor); OA devices such as electronic devices used in offices; and AV devices, such as a television, recording device, radio, printer, copier, and facsimile machine is molded with plastic and a knit/woven fabric is pasted to the plastic substrate.

## FIG. 4

EP 2 481 556 A1

**Description**

The present invention relates to a casing for an electronic device, such as a portable telephone and personal computer; a method for manufacturing the same; and an electronic device using the same and, more particularly, to a casing made of plastic.

Plastic (synthetic resin) has a low specific gravity, is excellent in strength, and can be easily molded into any intended shape. Therefore, it is frequently used for many purposes as a casing (case, housing, etc.) of various electronic devices, such as compact electronic devices, e.g., a mobile terminal (portable telephone etc.), portable gaming terminal, and portable player; a personal computer (main unit and monitor); AV devices, such as a television, various kind of recording devices, and radio; and OA devices such as electronic devices used in offices etc., e.g., a printer, copier, and facsimile machine.

There are many classes of plastic. Various types of plastic excellent in weatherability, impact resistance, transparency, surface hardness, elasticity, toughness, etc., are used according to their uses. Also, there is fiber-reinforced plastic (FRP) reinforced by glass fiber.

However, the characteristics of the various different types of plastic have merits and demerits. For example, an olefin-based resin, such as polyethylene and polypropylene, or nylon has a soft surface and flexibility; however, their surfaces have drawback of being easy to be damaged. In contrast, polystyrene, acrylic resin, acrylonitrile styrene resin (AS), etc., are excellent in transparency and surface hardness, but they have drawback of being fragile and easy to crack. On the other hand, an acrylonitrile butadiene styrene (ABS) is used frequently in household appliances, automotive parts, etc., because of its excellent mechanical strength, but it has drawback of being prone to yellow and easy to change its color along the passage of time.

A stacked body, in which plastic is used as a substrate and other synthetic resin film layer and fiber layer are stacked on the surface of the substrate, has been known before. For example, hollow plastic articles have been proposed, to which a feeling of luxury can be imparted by pasting a fiber sheet to the surface of the plastic articles to improve their external appearance and touch (for example, see Patent Documents 1 to 3). Also, a fiber-reinforced stacked body, which is a stacked body of canvas and a rigid material made of synthetic resin and fiber-reinforced plastic, has been proposed as shelf/rack materials for a vehicle used for carrying goods by a truck etc.; civil engineering/building materials; as well as interior materials (see Patent Document 4). Also, there have been proposed various plastic products, of which the design properties are improved by the use of a fabric. An example is a fabric-covered resin molded product that uses a pattern formed in a fabric as a pattern of the resin-molded product. Such a product is made by pasting a nap-raised fabric to the surface or by providing a decorative layer on the surface of a substrate made of a thermosetting resin, wherein the decorative layer is a transparent thermosetting resin into which a fabric is sealed (for example, see Patent Documents 5, 6, etc.).

However, the above-mentioned stacked body of plastic and fiber layer is used only in vessels; containers; tanks; chairs; interiors for vehicles (armrests, headrests, rear parcel shelves, ducts); shelf/rack materials for vehicles; civil engineering/building materials; interior materials; building plastic molded products in the form of a panel, such as interior walls, partitions, doors, etc., of buildings. It is also used only in the manufacture of resin molded products that make use of the patterns as they are by processing part of flags, cloth wrappers, split curtains, silk wrapping cloths, handkerchiefs, Japanese clothes, Western clothes, etc. However, any application examples to electronic devices manufactured industrially have not yet been known.

On the other hand, as a countermeasure against static electricity in a plastic molded product, an antistatic agent is kneaded into a raw material resin. Most of the antistatic agents are surfactants, which gradually migrate to the surface of the molded product along the passage of time and absorb moisture in the air to suppress generation of static electricity. However, the effect of this method is not sufficient in many cases. And the amount of the antistatic agent decreases through migration. Therefore, the durability of the effect is also problematic. Moreover, as a casing of a product incorporating electronic devices, such as a computer, the absorption of moisture as described above is not preferable, because it may cause a malfunction or trouble, such as short circuit in the electronic devices.

As a casing for an electronic device, a plastic casing for an electronic device has been proposed, which is a plastic casing provided with an electromagnetic shield and internally accommodating electronic devices. In the electromagnetic shield, a mesh-like metal wire for the electromagnetic shield is molded integrally. The shield is capable of providing a secure electromagnetic shield effect and a dustproof effect even when heat dissipating openings or sound dissipating openings are provided in the casing in accordance with various parts mounted on the electronic device or when internal dustproof is required (see Patent Document 7). It has also been proposed to make the energy produced by electric devices harmless in magnetic resonance. Such energy includes electromagnetic waves, static electricity, radiations, ultraviolet, and harmful sound waves. The proposal includes use of materials to which EM (Effective Microorganisms) ceramic is attached, painted, or mixed as materials as front faces, wall faces, etc., of electronic, electric devices, such as a television, computer, air conditioner, and portable telephone, machines such as an automobile and electric car, and interiors (see Patent Document 8), etc. Further, there have been proposed a protective case to protect a portable electronic device from humidity and dust so that it can be carried anywhere; a protective cover for an electronic device hard to be damaged when it is handled during the manufacturing process thereof and capable of preventing damage of an electronic part due to static electricity; and a protective case for a portable electronic device, etc. (see Patent Documents 9, 10, etc.). Furthermore, there has been proposed a nonconductive metal bright plating having, on a substrate, a first resin applied layer, a nonconductive metal deposited film and a second resin applied layer. The first resin applied layer is formed on the surface of a substrate on which a film is to be formed by application and drying. The nonconductive metal deposited film has metal brightness of an extremely thin film and is vacuum-deposited on the first resin applied layer by heating tin or an alloy including tin and indium in a vacuum. The second resin applied layer is formed on the nonconductive metal deposited film by application and drying. And the plating is effective as a countermeasure against electrostatic destruction of a resin processed plate or resin processed case. There has also been proposed a method for forming the nonconductive metal bright plating (see Patent Document 11). The following documents are incorporated by reference into the specification of the present application in their entirety.

[Patent Document 1] JP 57-49534 A
[Patent Document 2] JP 04-79820 B
[Patent Document 3] JP 06-32350 B
[Patent Document 4] JP 10-146907 A
[Patent Document 5] JP 10-156927 A
[Patent Document 6] JP 2001-71422 A
[Patent Document 7] JP 2001-267775 A
[Patent Document 8] JP 2003-92487 A
[Patent Document 9] JP 2005-135425 A
[Patent Document 10] JP 2004-128173 A
[Patent Document 11] JP 2006-281726 A

As described above, conventionally, as to plastic products, there have been known a variety of resins, molding methods, uses, and further, compound materials stacked with a fiber layer. Further, for electronic devices, there have been proposals of various countermeasures against dust, countermeasures against static electricity, etc. However, most of them were to mix conductive powder etc. into a resin itself of a plastic molded product constituting a casing. There has been no proposal of an electronic device in which a composite material of a plastic substrate and a fiber layer is used as the casing, and such a casing has not yet been manufactured and sold. As a result of research by the inventor of the present invention, however, a surprising knowledge was obtained. That is, by pasting a knit/woven fabric to form a fiber layer on the surface of a casing made of plastic for an electronic device, it is possible to obtain an electronic device capable of preventing malfunctions and trouble of the electronic device due to static electricity, and further, capable of preventing dust from sticking, and excellent in impact resistance and vibration-damping property, and durability and at the same time having excellent design properties. The present invention has been accomplished based on the knowledge above.

That is, a first aspect of the present invention is a casing for an electronic device characterized in that a knit/woven fabric is pasted to a plastic substrate of the casing.

In a preferred embodiment, the knit/woven fabric is pasted to the plastic substrate with an adhesive and an optional primer.

In a preferred embodiment, the knit/woven fabric is pasted to the plastic substrate by heating and pressing.

In a preferred embodiment, the plastic substrate is an injection-molded product.

In a preferred embodiment, the plastic substrate is made of thermoplastic plastic.

In a preferred embodiment, the thermoplastic plastic is at least one plastic selected from the group consisting of a polyolefin-based resin, styrene-based resin, saturated polyester-based resin, methacrylic resin, and polyamide resin.

In a preferred embodiment, the fiber constituting the knit/woven fabric is at least one fiber selected from the group consisting of cotton, rayon, silk, wool, polyester fiber, acrylic fiber, and acrylic-based fiber.

A second aspect of the present invention is a method for manufacturing a casing for an electronic device characterized in that the substrate of the casing is molded with plastic and a knit/woven fabric is pasted to the substrate molded with plastic.

In a preferred embodiment, the knit/woven fabric is pasted to the substrate with an adhesive and an optional primer.

In a preferred embodiment, the knit/woven fabric is pasted to the substrate by heating and pressing.

In a preferred embodiment, the substrate is molded by injection molding.

A third aspect of the present invention is an electronic device using the casing of the present invention as described above and a fourth aspect of the present invention is an electronic device using a casing manufactured by the method of the present invention as described above.

In the casing for an electronic device according to the present invention, the substrate is made of plastic. Therefore, by injection molding etc., it is possible to impart an arbitrary shape to such products as compact electronic devices, e.g., a mobile terminal (portable telephone etc.), portable gaming terminal, and portable player; a personal computer (main unit and monitor); and various electric devices, such as OA devices and AV devices, in which electronic parts, such as an electronic circuit and computer, are incorporated therein, e.g., a television, recoding device, radio, electronic devices used in offices, such as a printer, copier, and facsimile machine.

In the casing for an electronic device of the present invention, a knit/woven fabric is pasted to the plastic substrate and the surface of the plastic is coated with a fiber layer of a knit/woven fabric. Therefore, the impact strength of the plastic substrate is improved. Further, due to the fiber layer of knit/woven fabric, the vibration-damping property of the casing is improved. Thereby, it can be expected to obtain the effect of preventing malfunctions and breakage of an electronic device due to impact or vibrations. Furthermore, the knit/woven fabric that is pasted functions as a protective layer. Therefore, it is also possible to prevent damage to the casing surface, sticking of fingerprints, and other pollutions.

The surface resistivity of the casing for an electronic device is reduced by the fiber layer of knit/woven fabric. As the result, sticking of dust due to static electricity is prevented. Malfunctions and breakage of an electronic device due to generation (discharge) of static electricity are also prevented.

When a knit/woven fabric is pasted to the external surface of the plastic substrate constituting a casing, it is possible to apply the design of the knit/woven fabric that can be selected arbitrarily to the casing for an electronic device as it is. And it is possible to manufacture a casing for an electronic device excellent in design properties without the need to perform surface treatment or surface processing, such as painting and plating painting. Moreover, by pasting combination of two or more fabrics having different patterns, it is possible to manufacture plastic products having various designs that could not be expressed by painting or plating. Furthermore, it is easy to change the design of, for example, a portable telephone, a portable gaming machine, etc., by changing the knit/woven fabric pasted to the outer surface of the casing. In this case, it may also be possible to paste a new knit/woven fabric after peeling off the pasted knit/woven fabric or alternatively, paste a new knit/woven fabric on the pasted knit/woven fabric in an overlapping manner.

When the external surface of the product in the plastic substrate is coated with a knit/woven fabric, the weatherability of the casing for an electronic device is improved due to the effects of light shielding, heat shielding, etc., of the fiber layer of knit/woven fabric, and deterioration of the casing along the passage of time is suppressed.

Furthermore, by the fiber layer including a pasted knit/woven fabric, which would act as a heat insulating layer, the effect of preventing dew condensation can also be expected.

Consequently, according to the present invention, it is possible to manufacture and provide an electronic device with improved durability and desirable design possibility, in which the functions of the computer and electronic circuit incorporated in its casing are stable.

The invention is further disclosed with reference to the drawings:

Fig. 1 is an illustrative diagram of the test method for measuring a loss factor to examine the vibration-damping property.

Fig. 2 is an illustrative diagram of the shape of test chip used to measure a loss factor to examine the vibration-damping property.

Fig. 3 is a graph representing an approximate straight line of response displacement in a loss factor measurement test, wherein x represents the amplitude and y represents time.

Fig. 4 is an illustrative diagram of the apparatus and raw material (resin plate) showing the method for pasting a woven fabric to a plastic substrate by a heating/pressing method.

The casing for an electronic device according to the present invention is characterized in that a knit/woven fabric is pasted to a plastic substrate.

The casing for an electronic device, to which the present invention pertains, is not limited in particular. It includes, for example, a plastic casing including an exterior material, housing, case, or cover of various electronic devices in which electronic parts, e.g., an electronic circuit and computer, are incorporated internally, such as compact electronic devices, e.g., a mobile terminal (portable telephone, etc.), portable gaming terminal, and portable player; a personal computer (main unit and monitor); OA devices such as electronic devices used in offices; and AV devices, such as a television, recording device, radio, printer, copier, and facsimile machine, etc.

In the present invention, the raw material resin of the plastic formed into the substrate of the casing for an electronic device and the molding method thereof are not limited in particular.

As the raw material resin, any of thermoplastic resins and thermosetting resins can be used. The thermoplastic resin includes, for example, a olefin-based resin, such as polyethylene and polypropylene; a styrene-based resin, such as polystyrene, acrylonitrile butadiene styrene resin (ABS) and acrylonitrile styrene resin (AS); a methacrylic resin; a saturated polyester-based resin, such as polyethylene terephthalate and polybutylene terephthalate; a polyamide resin, such as aliphatic polyamide (nylon) and aromatic polyamide resin (aramide); an ethylene acetate vinyl resin (EVA); a vinyl chloride resin; a vinylidene chloride resin; polycarbonate; polyacetal; polyphenylene oxide; polylsufone; a fluorocarbon resin; a methacrylic resin, etc. Further, it is also possible to use olefin-based or styrene-based thermoplastic elastomer. The thermosetting resin includes, for example, an unsaturated polyester, polyurethane, epoxy resin, phenol resin, alkyd resin, silicon resin, diallyl phthalate resin, etc. It is also possible to use glass fiber-reinforced plastic (FRP).

As a method for molding plastic to form a substrate of a casing, injection molding, extrusion molding, blowing molding, etc., are generally used in the case of a thermoplastic resin, and compression molding, transfer molding, stacking molding, injection molding, etc., are generally used in the case of a thermosetting resin. Of these, injection molding is widely used because of its capability of mass production and easy molding of a molded product even into a complicated shape. Further, the plastic substrate used in the present invention may be any of a non-foamed molded product and a foamed molded product.

In the present invention, a knit/woven fabric (hereinafter, simply referred to as "fabric" in some cases) pasted to the surface of a plastic substrate includes a fabric obtained by processing a fiber into a shape of a thin plane and its similar products. Typical examples are woven fabric and knitted fabric.

With regard to the class of fiber constituting the fabric, any of a natural fiber and a chemical fiber may be used. The natural fiber includes, for example, a vegetable fiber, such as a cotton, hemp, and coconut fiber; and an animal fiber, such as silk, wool, cashmere, and mohair. The chemical fiber, includes, for example, a synthetic fiber such as nylon, polyester, acrylic, acrylic-based (modacrylic), polyvinyl chloride, polyurethane, spandex, vinylidene, polyethylene, etc.; a composite fiber composed of two or more synthetic fibers; a semi-synthetic fiber such as acetate, triacetate, etc.; and a regenerated fiber such as rayon, cupra, regenerated polyester, etc. It may also be possible to make a woven fabric or knitted fabric using one of these fibers or a combination of two or more fibers. Blended spun yarn of the different fibers mentioned above may also be used. The class and fineness (thickness) of the fiber constituting the knit/woven fabric are not limited in particular. A usual thickness used for clothing materials or curtain materials may be chosen.

The composition of the fiber in the knit/woven fabric is not limited in particular. The composition of a woven fabric, includes, for example, a plain weave, twilled weave, satin weave, leno weave, Dobby, Jacquard, double weave, and pile weave. More specifically, it includes a plain weave, such as canequim (unbleached muslin, calico), tenjiku (jersey stitch), poplin, broad cloth, lawn, and Oxford; a twilled weave, such as a plain weave of thick silk and denim; a pile weave, such as velveteen and corduroy, etc. The knitted fabric includes weft knit and warp knit, and any of them may be acceptable. In general, a knitted fabric is superior in expansion/contraction performance as compared with a woven fabric. Therefore, the knitted fabric is convenient for pasting to a plastic substrate of casing having a shape of three-dimensional curved surface. The weft knit includes circular knit, weft knit, jersey, etc. Specific composition includes piqué; hexagonal pattern; crepe; a plain knit, such as lace knit and pile knit; a rib knit, such as broad rib knit, hexagonal (rib) knit, ripple, cable stitch, etc.; an interlock stitch, such as four-needle interlock stitch, single piqué, twilled knit, three-needle interlock stitch herringbone, etc., as well as a peal knit, such as basket knit. The warp knit includes a tricot knit, such as half tricot, satin tricot, double tricot, etc.; and a raschel knit, such as raschel check, raschel lace, tulle mesh, milanese, etc.

Among the knit/woven fabrics having the various compositions as described above, typical ones are the plain weave product and the pile weave fabric, which is the plain weave product the surface of which is a brushed or flocked fabric. The plain weave product is a fabric woven by alternately changing the vertical positions of the warp and weft of the thread of weaving. The brushed fabric is a fabric produced by brushing the surface of a woven fabric, such as a plain weave product, woven by thread of weaving, with a brush made of metal or other materials to fluff it. The flocked fabric is a fabric produced by embedding, as a short fiber, thread of weaving into or bonding thread of weaving to a base fabric produced from a plain weave product. As the base fabric of the flocked fabric, the various woven fabrics and knitted fabrics mentioned above and combinations of those can be used besides the plain weave products.

As the woven fabric or knitted fabric of the plain weave product, the weaving method, the knitting method, and the size of the stitch of weaving or knitting are not limited in particular. It is preferable, however, that the stitches be rather dense in order to prevent an adhesive from oozing out through the stitches to the outer surface, when an adhesive is applied to the adhesion surface between the fabric and the surface of plastic substrate.

The knit/woven fabric used in the present invention may be fabrics made of fibers containing various functional additives, such as a sterilizing agent, antibacterial agent, and flame retardant; or fibers the surface of which is coated with a coating agent containing a sterilizing agent, antibacterial agent, and flame retardant. It may also be fabrics made of fibers to which water-repellent treatment or waterproofing treatment has been made.

The method for manufacturing a casing for an electronic device of the present invention is classified into various modes depending on the way of pasting a knit/woven fabric to the surface of a plastic substrate. Principal manufacturing methods include a method comprising integrating a knit/woven fabric with the surface of a substrate during the formation of the substrate and a method comprising forming a substrate and thereafter pasting a knit/woven fabric to the surface of the formed substrate. Further, the method for pasting a knit/woven fabric onto the surface of a formed substrate includes a method using an adhesive and a method by heating and pressing.

As the adhesive, it is possible to use various adhesives, such as an evaporation type, such as a solvent type and emulsion type; a reaction type, such as a thermosetting type and polymerization type; pressure-sensitive type; hot-melt type, etc. It is also possible to bond a fabric to the surface of plastic substrate using a thermoplastic resin in the form of a film (hereinafter, referred to as an "adhesive resin film" or simply as "resin film" in some cases) in addition to the above.

The type of adhesive is not limited in particular. It may be possible to determine an appropriate combination of adhesive and substrate that will produce excellent adhesion in view of the materials of the fabric and plastic substrate. With regard to the type of adhesives, the reaction type adhesive includes, for example, a thermosetting adhesive such as an amino resin, phenol resin, epoxy-based resin, polyurethane, unsaturated polyester, and thermosetting acrylic. The solvent type adhesive includes chloroprene rubber (CR), isoprene rubber (IR), styrene butadiene rubber (SBR), nitrile rubber (NBR), butylene rubber (BR), butyl rubber (IIR), etc. The emulsion type adhesive includes polyvinyl acetate-based emulsion, polyacrylic acid ester-based emulsion, etc. The hot-melt type adhesive includes those adhesives containing, as a main ingredient, poly isobutylene, polyvinyl ether, chlorinated rubber, natural rubber, poly vinyl butyral, poly acrylic acid ester, etc., to which a tackifier, plasticizer, etc., are blended. The hot-melt type adhesive further includes those adhesives composed of a thermoplastic resin as the base polymer and a tackifier, waxes, anti-oxidant, filler, plasticizer, etc., the thermoplastic resin being selected from ethylene-vinyl acetate copolymer (EVA), polyethylene, chlorinated polypropylene, copolymerized polyamide, poly vinyl formal, etc., as a main component. Among these adhesives, those including styrene butadiene rubber (SBR), acrylic resin, polyester, etc., as a main component are widely used.

The adhesive and adhesive resin film may contain a sterilizing agent and/or antibacterial agent. The sterilizing agent and antibacterial agent include p-hydroxybenzoic acid esters, sorbic acid, nonionic surfactant, metallic copper powder, etc. These can be used alone or in combination of two or more thereof.

The method for bonding a knit/woven fabric to a plastic substrate using an adhesive is a simple method capable of securing pasting a knit/woven fabric to a substrate of a casing for an electronic device having various irregularities.

In an embodiment of a method for bonding a knit/woven fabric to a plastic substrate using an adhesive, the adhesive is applied to the surface area of plastic substrate to which a knit/woven fabric is to be pasted and/or the opposite surface of the knit/woven fabric, and then, the knit/woven fabric is bonded to the surface of the plastic substrate with the adhesive. The amount of the adhesive to be applied is not limited in particular as long as the amount is enough to paste the fabric to the surface of the plastic substrate without exfoliation. It is preferable to bond the knit/woven fabric in such a manner that the adhesive does not ooze out to the outside surface of the knit/woven fabric. The area of the adhesive applied may be part of the area of the plastic substrate to which the knitted and woven fabric is to be pasted or of the knit/woven fabric. From the viewpoint of the adhesiveness between the plastic substrate and the knit/woven fabric, however, it is preferable to apply the adhesive to the entire surface of the area of the plastic substrate to which the knit/woven fabric is to be pasted and/or the entire surface of the knit/woven fabric.

The method for bonding a plastic substrate of a casing for an electronic device and a knit/woven fabric via a molten resin film is advantageous in that the strength of adhesion can be adjusted by cutting the resin film into a desired shape and further in that the adhesion can be done again comparatively simply.

In making the casing for an electronic device according to the present invention, it is also possible, in addition to the method using an adhesive described above, to paste a knit/woven fabric directly to a target region of the plastic substrate by heating/pressing. With this method, it is possible to easily paste a knit/woven fabric to the region of the plastic substrate of a casing for an electronic device to which the knit/woven fabric is to be pasted, when the region is a flat or slightly bent shape. The conditions of heating and pressing may appropriately be chosen depending on the melting point etc. of the plastic substrate and the knit/woven fabric to be pasted within the range in which a robust bonding between them is secured and their melting by heat and their deformation, breakage, etc. by pressing are avoided.

The shape of plastic substrate constituting the casing for an electronic device according to the present invention may be a plate-like shape the surface of which is flat, a bent shape, or further, a complicated three-dimensional shape.

Various modes of the present invention are described above; however, the present invention is not limited to the modes described above, and it is only necessary to meet the essential features of the present invention that a knit/woven fabric is pasted to a plastic substrate for an electronic device and a fiber layer is made on the surface of the substrate.

According to the present invention described above, it is possible to improve the design properties of an electronic device by decorating the surface of the electronic device with a knit/woven fabric by pasting the knit/woven fabric to the surface of plastic substrate to form a fiber layer. Further, attributable to this, it is possible to impart warmth, touch, texture, etc., inherent to a knit/woven fabric onto the surface of plastic products as novel surface characteristics that could not be achieved by the conventional surface treatment technology, such as application treatment and plating treatment, performed generally in the field of plastic products. Use of a knit/woven fabric having a complicated design, such as a patterned fabric, permits further remarkable improvement in design properties of the external appearance of plastic products. Further, by dying the fabric with various colors that are difficult to represent by a coating agent or by printing a pattern onto the fabric, it is possible to manufacture an electronic device having an external appearance with such colors that could not be achieved before. Further, fabrics can be cut freely, and as the result, it is possible to impart various designs onto the surface of an electronic device as occasion demands. Furthermore, it is possible to impart various novel designs onto the surface (of a casing) for a conventional plastic electronic device by using various combinations of the type of fabrics, the shapes of fabrics, etc.

According to the present invention, the fiber layer comprising a knit/woven fabric bonded to a casing functions as a protection layer. In the case the knit/woven fabric is pasted using an adhesive or adhesive resin film, the knit/woven fabric also functions as a cushion material (layer). As the result, it is possible to prevent damage to the surface of (a casing for) an electronic device. Further, dust, other stain components, and components that promote fading are physically prevented from sticking to the surface of (a casing for) an electronic device. As the result, it is possible to prevent the surface from staining and fading in color.

When the knit/woven fabric is pasted to the plastic casing via a thermoplastic adhesive or synthetic resin film, it is possible to easily weaken the adhesion by heating to melt the adhesive or adhesive resin film, and therefore, replacement of the knit/woven fabric with a new one can be done easily. Also in this case, it is possible to change the design of an electronic device comprising a plastic casing in a variety of ways by cutting fabrics into pieces of desired shape and combining the pieces.

Furthermore, by the fiber layer formed of the knit/woven fabric on the surface, it is possible to reduce the surface resistance of the resulting plastic product, to suppress generation of static electricity on the product surface. As the result, it is possible to prevent dust from sticking to the surface due to static electricity. It is also possible to prevent breakage of the resulting electronic device due to static electricity. Furthermore, vibration damping performance of the case is improved by the presence of the fiber layer formed by the above-mentioned knit/woven fabric. As the result, it is possible to make an electronic device with high durability against impact and vibration.

[Examples]

Hereinafter, various characteristics of a casing for the electronic device according to the present invention are explained based on experiment examples.

<Experiment example 1: Weatherability (fading) test>

A plastic test chip having a width of 5 cm, a length of 9 cm, and a thickness of 2 mm was fabricated by an ABS resin (Techno Polymer Co., Ltd.: 130NP). To the surface of the ABS test chip, a fabric was pasted with an SBR-based solvent type adhesive (Konishi Co., Ltd.; G Clear) and the fabric-pasted chip was subjected to irradiation for 300 hours in a fading tester (made by YASUDA SEIKI SEISAKUSHO, LTD., No. 5 MERCURY LAMP FADE METER; in conformity with JIS K-5400) (the conditions correspond to exposure to the sunlight at noon in summer for 325 days). The surface state after irradiation was observed. The results are shown in Table 1.

Table 1 Fading test

| Test chip | Fabric material | Blank (no fabric pasted) | Cotton | Cotton | Polyester | Nylon |
|---|---|---|---|---|---|---|
| | Color | | White | Black | White | White |
| Surface state after 300 hour irradiation | | Entire surface has yellowed | Slightly yellowed | Unchanged | Unchanged | Unchanged |

As shown in Table 1, weatherability (fading) was improved by pasting a fabric to the plastic surface.

[Example 1: Pasting of knit/woven fabric with adhesive]

<Raw materials used>

The type of plastic resins and woven fabrics used are shown in Table 2 and Table 3.

Table 2 Plastic

| Type of resin | Company name | Product name | Grade |
|---|---|---|---|
| Polypropylene (PP) | Prime Polymer Co., Ltd. | Prime Polypro (registered trademark) | J105G |
| ABS resin | Techno Polymer Co., Ltd. | Techno ABS (registered trademark) | 130NP |
| Polystyrene (GP-PS) | CHIMEI CORPORATION | POLYREX (registered trademark) | PG80N |

(continued)

| Type of resin | Company name | Product name | Grade |
|---|---|---|---|
| Methacrylic resin (acrylic) | Mitsubishi Rayon Co., Ltd. | ACRYPET (registered trademark) | MD001 |
| Vinyl chloride resin | SHOWA KASEI Co., Ltd. | Kane Vinyl (registered trademark) | KVC850 |

Table 3 Fabrics

| | Cotton | | Polyester | | Rayon |
|---|---|---|---|---|---|
| | Plain weave | | Plain weave [1] | Brushed [2] | Plain weave [1] |
| | Thin fabric [1] | Thick fabric [1] | | | |
| Thickness (mm) | 0.19 | 0.25 | 0.37 | 0.43 | 0.36 |

*1) Purchased at Toraya Shouten in SHIN-OSAKA SEN-I CITY

2) Made by KYOTO PILE SEN-I KOGYO & CO., LTD.

<Experiment example 2; Examination of adhesive>

Adhesiveness between various fabrics and plastic was examined using various adhesives shown in Table 4 below. The results are shown together in Table 4.

Table 4 Adhesion test

| Adhesive | | | Woven fabric | | | Plastic | | |
|---|---|---|---|---|---|---|---|---|
| Component | Product No. | Company name | Cotton | Rayon | Polyester | ABS | GP-SP | Acrylic |
| Urethane based | UM700 | CEMEDINE Co., Ltd. | ◎ | ◎ | ◎ | ◎ | ◎ | ◎ |
| Styrene butadiene rubber | TA34 | Sumitomo 3M Limited | ○ | △ | △ | ○ | ○ | ○ |
| Chloroprene rubber | Aqueous G | Konishi Co., Ltd. | ○ | ○ | ○ | ○ | ○ | ○ |
| Nitrile rubber | G103 | Konishi Co., Ltd. | ○ | ○ | ○ | ◎ | ◎ | ◎ |
| Ethylene-vinyl acetate copolymer | Polysol P-62N | SHOWA HIGHPOLYMER CO., LTD. | ◎ | ◎ | ◎ | ◎ | ◎ | ◎ |
| *As undercoating, Primer ("Polynal No. 380" OHASHI CHEMICAL INDUSTRIES LTD.) was applied and after drying, each adhesive was coated thereon and adhesiveness was examined.<br>*Evaluation criteria<br>　　◎ :Very excellent<br>　　○ : Excellent<br>　　△ : Rather poor | | | | | | | | |

<Experiment example 3: Izod impact test>

By the method shown below, the effect of improving the impact resistance performance of plastic by pasting a woven fabric thereon was examined. The constitutions of samples used in the test and the test results are shown in Table 5.

Test method

Tester for measurement: YASUDA SEIKI SEISAKUSHO, LTD.
Conditions of measurement: In conformity with JIS K-71110
Test chip (mm): 64 × 12.7 × 12.7

Adhesive; Urethane-based adhesive "UM700" (CEMDINE Co., Ltd.)
Undercoating; Primer ("Polynal No. 380" OHASHI CHEMICAL

INDUSTRIES LTD.)

Method of measurement: A fabric was pasted to a notch groove surface of plastic chip and the impact was exerted from the side of the fabric.

### Table 5 Results of Izod impact test

| Test sample | Measurement result | Impact strength | |
|---|---|---|---|
| | | Measured value (kgf/cm/cm$^2$) | SI(J/m) |
| Polypropylene (PP) | Blank | 6.7 | 65.66 |
| | Cotton[1] | 8.5 | 83.3 |
| | Polyester[2] | 10.8 | 105.84 |
| ABS resin | Blank | 29.0 | 284.2 |
| | Cotton[1] | 30.2 | 295.96 |
| | Polyester[2] | 32.8 | 321.44 |
| Polystyrene (GP-PS) | Blank | 3.7 | 36.26 |
| | Cotton[1] | 6.1 | 59.78 |
| | Polyester[2] | 13.7 | 134.26 |
| Methacrylic resin (acrylic) | Blank | 3.0 | 29.4 |
| | Cotton[1] | 6.0 | 58.8 |
| | Polyester[2] | 9.5 | 93.1 |
| Vinyl chloride resin | Blank | 43.5 | 426.3 |
| | Cotton[1] | 44.6 | 437.08 |
| | Polyester[2] | 45.4 | 444.92 |

*1) Cotton: plain weave (0.19 mm thick)
2) Polyester: plain weave (0.37 mm thick)

As shown in Table 5, by pasting a fabric to the surface of plastic chip, the impact resistance of various plastic was improved.

<Experiment example 4: Measurement of surface resistivity>

In order to examine the effect of preventing and suppressing dust from sticking due to static electricity by pasting a knit/woven fabric to the surface of a plastic casing, the surface resistivity ($\Omega/\square$) was measured.

Details of test

Temperature/humidity: 28°C, 50%RH
Test for measurement: Advance Co. Ltd. Digital Ultrahigh Resistance/Microcurrent Meter R8340A, RESISTIVITY CHAMBER R12702
Test chip: Circular shape having a diameter of 100 mm and a thickness of 2 mm was molded by hot press.
Pasted with urethane-based adhesive "UM700" (CEMEDINE Co., ltd.) and then subjected to the measurement after drying.
Undercoating: Primer ("Polynal No. 380" OHASHI CHEMICAL INDUSTRIES LTD.)
Others: The measured value was the average of duplicate. The measured value was read to the second decimal place and the average value was rounded off to the second decimal place.

Table 6 Measurement result of surface resistivity ($\Omega/\square$)

| Adhesive | Fabric | | Polypropylene (PP) | ABS resin | Polystyrene (GP-PS) | Methacrylic resin (acrylic) |
|---|---|---|---|---|---|---|
| Ethylene-vinyl acetate copolymer *1 | Thin fabric | Cotton | $1.4 \times 10^{10}$ | $1.6 \times 10^{10}$ | $1.3 \times 10^{10}$ | $1.6 \times 10^{10}$ |
| | | Polyester | $2.8 \times 10^{9}$ | $3.1 \times 10^{9}$ | $3.1 \times 10^{9}$ | $3.8 \times 10^{9}$ |
| | Thick fabric | Cotton | $8.7 \times 10^{9}$ | $1.0 \times 10^{9}$ | $8.3 \times 10^{9}$ | $1.1 \times 10^{9}$ |
| | | Polyester | $6.7 \times 10^{11}$ | $7.8 \times 10^{11}$ | $6.7 \times 10^{11}$ | $6.7 \times 10^{11}$ |
| | | Rayon | $7.2 \times 10^{11}$ | $6.8 \times 10^{11}$ | $4.7 \times 10^{11}$ | $8.7 \times 10^{11}$ |
| Urethane-based *2 | Thin fabric | Cotton | $8.8 \times 10^{9}$ | $1.1 \times 10^{10}$ | $1.1. \times 10^{10}$ | $7.3 \times 10^{9}$ |
| | | Polyester | $2.9 \times 10^{10}$ | $1.1 \times 10^{10}$ | $4.5 \times 10^{10}$ | $1.5 \times 10^{10}$ |
| | Thick fabric | Cotton | $1.0 \times 10^{10}$ | $3.7 \times 10^{9}$ | $5.2 \times 10^{9}$ | $6.5 \times 10^{9}$ |
| | | Polyester | $1.6 \times 10^{11}$ | $4.5 \times 10^{10}$ | $9.7 \times 10^{10}$ | $8.9 \times 10^{10}$ |
| | | Rayon | $3.6 \times 10^{10}$ | $2.5 \times 10^{10}$ | $8.2 \times 10^{10}$ | $7.1 \times 10^{10}$ |
| Blank | | | $2.8 \times 10^{15}$ | $1.9 \times 10^{16}$ | $1.7 \times 10^{16}$ | $1.2 \times 10^{16}$ |

* 1) Ethylene-vinyl acetate copolymer "Polysol P-62N" from SHOWA HIGHPOLYMER CO., LTD.
2) Urethane-based "UM700" from CEMEDINE Co., ltd.

In general, it is known that the surface resistivity of plastic is about $10^{16}$ $\Omega/\square$ and dust tends to stick thereto due to static electricity. In the past, an antistatic agent was kneaded into the raw material resin of plastic in order to prevent and suppress dust sticking. The typical antistatic agent includes a hydrophilic surfactant, which gradually migrates to the surface of a plastic product along the passage of time and thereby the plastic absorbs moisture in the air to suppress generation of static electricity. However, the surface resistivity of plastic could only be reduced down to about $10^{12}$ by the surfactant and further the amount of the surfactant decreases through migration, and therefore, the durability of the effect was problematic. In contrast to this, according to the present invention, as shown in Table 5, by pasting a knit/woven fabric to the surface of the plastic, it is possible to reduce the surface resistivity down to about $10^{9}$ to $10^{11}$ $\Omega/\square$, and therefore, it is possible to prevent and suppress dust from sticking. Further, the present invention is free from the problem of reduction in the amount of surfactant due to its migration, and therefore, the effect is durable.

<Experiment example 5: Measurement of vibration-damping property>

The vibration control performance of a material, such as plastic and metal, is expressed by using a notational system called a loss factor (symbol is η: eta). Materials in general have a capability of converting vibration energy into heat energy. The loss factor is a measure of the magnitude of the capability by a numerical value. The greater the value of the loss factor, the higher the vibration control performance. In view of this, the vibration-damping property was measured for test chips which are polypropylene or ABS resin to which different woven fabric is pasted in order to examine the influence of pasting of a knit/woven fabric to a plastic casing on the vibration control performance of the plastic casing according to the present invention. In the test, the loss factor was determined based on JIS G0602 "Test methods for vibration-damping property in laminated damping steel sheets".

How to determine loss factor

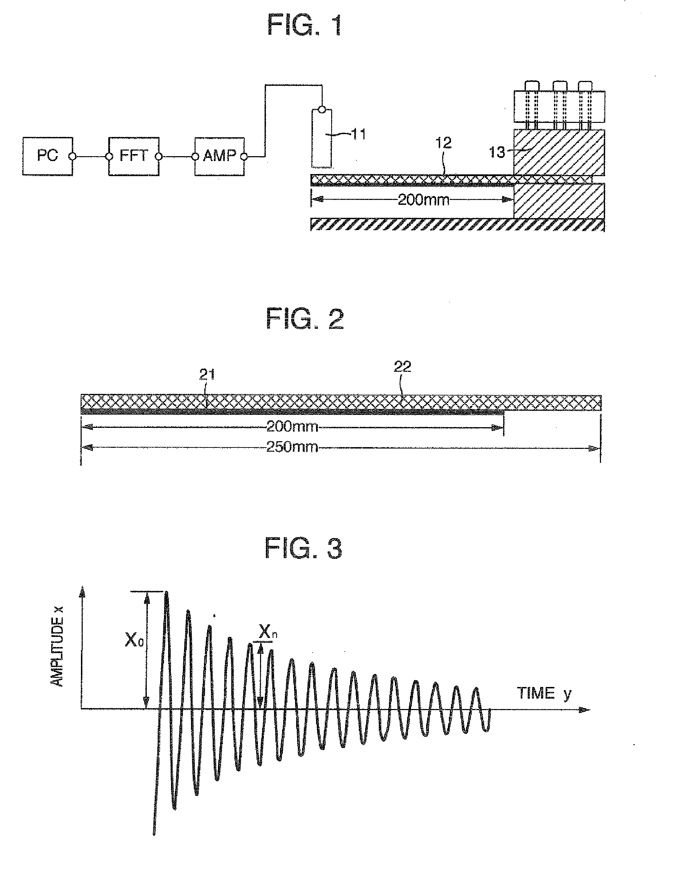

The loss factor was determined by the equation below from the damping free vibration waveforms of bending vibration by the impact vibrating method with one end fixed, according to JIS G0602 (see Fig. 1 and Fig. 2).

[Mathematical expression 1]

$$\eta = 2 \cdot \ln(\tan\theta)/\sqrt{((2\pi)^2 + [\ln(\tan\theta)]^2)}$$

Here, local maxima $X_0$, $X_1$, ..., $X_n$ of the response displacement were read and the loss factor was calculated from the gradient of an approximated straight line shown in Fig. 3 by plotting $X_{n+1}$ along the horizontal axis and $X_n$ along the vertical axis. The calculation interval (between $X_o$ and $X_n$) was set to 3.0 mm to 0.5 mm except for the response displacement at the time of the initial impact.

<Measurement conditions>

Length of protrusion of cantilever; 200 mm
Vibration position; Free end side of cantilever
Vibration method; Step relaxation vibration

<Measuring device>

CCD Laser Displacement Meter (LK-GD5000, KEYENCE CORPORATION) FTT Analyzer (Photon II, AR BROWN CO., LTD.)

<Test sample>

Tested samples and test results are shown in Table 7.

Table 7 Details and results of vibration-damping property test

| Plastic substrate | Test chip | Adhesive | Woven fabric | Thickness of substrate (fixed part) t (mm) | | Loss factor [×10⁻²] | Average of loss factor [×10⁻²] | Eigenfrequency [Hz] |
|---|---|---|---|---|---|---|---|---|
| Polypropylene | A | None (blank) | | No.1 | 1.97 | 4.98 | 4.24 | 12.54 |
| | | | | No.2 | 1.98 | 3.91 | | 14.37 |
| | | | | No.3 | 2.00 | 3.82 | | 14.37 |
| | A-I-1 | Ethylene-vinyl acetate, Polysol P-62N | Cotton/ plain weave (0.25 mm) | No.1 | 1.96 | 5.42 | 4.56 | 12.36 |
| | | | | No.2 | 1.98 | 4.22 | | 13.92 |
| | | | | No.3 | 1.98 | 4.03 | | 13.82 |
| | A-I-2 | | Polyester/ plain weave (0.37 mm) | No.1 | 1.97 | 6.84 | 6.15 | 11.99 |
| | | | | No.2 | 1.98 | 5.78 | | 13.55 |
| | | | | No.3 | 1.97 | 5.82 | | 13.28 |
| | A-I-3 | | Rayon/ plain weave (0.36 mm) | No.1 | 1.97 | 4.88 | 4.24 | 11.90 |
| | | | | No.2 | 1.98 | 3.90 | | 13.28 |
| | | | | No.3 | 1.97 | 3.94 | | 13.37 |
| | A-II-1 | Urethane-based, UM700 | Cotton/ plain weave (0.25 mm) | No.1 | 1.97 | 6.53 | 5.47 | 12.91 |
| | | | | No.2 | 1.96 | 4.96 | | 14.56 |
| | | | | No.3 | 1.97 | 4.92 | | 14.37 |
| | A-II-2 | | Polyester/ plain weave (0.37 mm) | No.1 | 1.97 | 7.37 | 6.38 | 11.44 |
| | | | | No.2 | 1.97 | 5.86 | | 13.00 |
| | | | | No.3 | 1.99 | 5.91 | | 13.09 |
| | A-II-3 | | Rayon/ plain weave (0.36 mm) | No.1 | 1.97 | 5.49 | 4.63 | 11.81 |
| | | | | No.2 | 1.98 | 4.20 | | 13.28 |
| | | | | No.3 | 1.98 | 4.20 | | 13.09 |

(continued)

| Plastic substrate | Test chip | Adhesive | Woven fabric | Thickness of substrate (fixed part) t (mm) | | Loss factor [$\times 10^{-2}$] | Average of loss factor [$\times 10^{-2}$] | Eigenfrequency [Hz] |
|---|---|---|---|---|---|---|---|---|
| ABS resin | B | None (blank) | | No.1 | 1.96 | 1.23 | 1.31 | 11.90 |
| | | | | No.2 | 2.53 | 1.35 | | 14.19 |
| | | | | No.3 | 2.55 | 1.35 | | 14.47 |
| | B-I-1 | Ethylene-vinyl acetate, Polysol P-62N | Cotton/ plain weave (0.25 mm) | No.1 | 1.98 | 1.57 | 1.70 | 11.90 |
| | | | | No.2 | 2.55 | 1.75 | | 14.37 |
| | | | | No.3 | 2.55 | 1.79 | | 14.37 |
| | B-I-2 | | Polyester/ plain weave (0.37 mm) | No.1 | 1.95 | 3.38 | 3.25 | 11.44 |
| | | | | No.2 | 2.55 | 3.20 | | 13.73 |
| | | | | No.3 | 2.53 | 3.18 | | 13.82 |
| | B-I-3 | | Rayon/ plain weave (0.36 mm) | No.1 | 1.97 | 1.37 | 1.43 | 11.54 |
| | | | | No.2 | 2.54 | 1.44 | | 13.92 |
| | | | | No.3 | 2.55 | 1.48 | | 14.01 |
| | B-II-1 | Urethane-based, UM700 | Cotton/ plain weave (0.25 mm) | No.1 | 1.95 | 2.86 | 2.72 | 12.18 |
| | | | | No.2 | 2.54 | 2.52 | | 15.01 |
| | | | | No.3 | 2.55 | 2.78 | | 15.20 |
| | B-II-2 | | Polyester/ plain weave (0.37 mm) | No.1 | 1.98 | 3.14 | 3.02 | 11.35 |
| | | | | No.2 | 2.53 | 3.01 | | 13.73 |
| | | | | No.3 | 2.53 | 2.90 | | 13.64 |
| | B-II-3 | | Rayon/ plain weave (0.36mm) | No.1 | 1.98 | 1.76 | 1.72 | 11.54 |
| | | | | No.2 | 2.55 | 1.69 | | 13.92 |
| | | | | No.3 | 2.54 | 1.72 | | 13.73 |

It was found that the loss factor was increased and the vibration control performance was improved by pasting the woven fabric to the plastic substrate as shown in Table 7. Further, it was also found that as to the type of woven fabric, the increase in loss factor was remarkable when the polyester woven fabric was pasted, and therefore, the effect of improving the vibration control performance was remarkable. Furthermore, it was also found that, as to the polypropylene and the ABS resin, the effect of improving the vibration control performance was higher when the woven fabric was pasted on the ABS resin.

[Example 2: Pasting of woven fabric by heating/pressing]

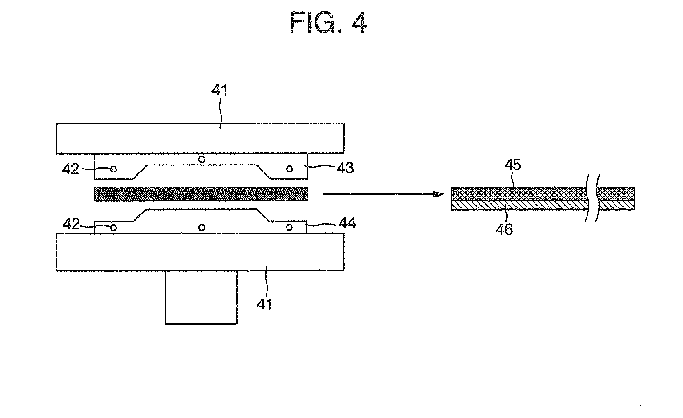

A polyester woven fabric (plain weave, thickness: 0.3 mm, 1 mm) was pasted to a plate-like plastic substrate (polypropylene, ABS resin) having a length of 100 mm, a width of 50 mm, and a thickness of 2 mm by the heating/ pressing method under the conditions shown in Table 8 using a press-molding machine shown in Fig. 4.

Table 8 Molding (heating, pressing) conditions

| Polypropylene | | ABS resin | |
|---|---|---|---|
| Prime polypro (registered trademark) J105G | | Techno ABS (registered trademark) 130NP | |
| Die (upper) | Die (lower) | Die (upper) | Die (lower) |
| 180˚C | 170˚C | 180˚C | 170˚C |

(continued)

| Polypropylene | | ABS resin | |
|---|---|---|---|
| Prime polypro (registered trademark) J105G | | Techno ABS (registered trademark) 130NP | |
| Die (upper) | Die (lower) | Die (upper) | Die (lower) |
| Molding pressure: 305 kg | | | |
| Molding time: 5 min | | | |

<Experiment example 6: Izod impact test>

The Izod impact test was conducted on the plastic molded products to which the polyester woven fabric was pasted by the heating/pressing method as described above in the same manner as in Experiment example 3. The results are shown in Table 9.

Table 9 Result of Izod impact test

| Polypropylene | | | ABS resin | | |
|---|---|---|---|---|---|
| Blank (without woven fabric) | Thickness of polyester woven fabric | | Blank (without woven fabric) | Thickness of polyester woven fabric | |
| | 0.3 mm | 1 mm | | 0.3 mm | 1 mm |
| 3.85 | 4.87 | 6.67 | 7.45 | 9.03 | 14.80 |
| * Test chip: 60 mm long, 1.3 mm wide | | | | | |

<Experiment example 7: Measurement of surface resistivity>

The surface resistivity ($\Omega/\square$) of the plastic molded products to which the polyester woven fabric was pasted by the heating/pressing method as described above was measured in the same manner as in Experiment example 4. The results are shown in Table 10.

Table 10 Measurement result of surface resistivity ($\Omega/\square$)

| Polypropylene | | ABS resin | |
|---|---|---|---|
| Blank (without woven fabric) | Polyester woven fabric (thick) | Blank (without woven fabric) | Polyester woven fabric (thick) |
| $1.22 \times 10^{16}$ | $3.83 \times 10^{10}$ | $2.47 \times 10^{16}$ | $1.31 \times 10^{10}$ |

As shown in Table 9 and Table 10, the effect of improving impact resistance and surface resistance by pasting the woven fabric can be obtained also in the plastic molded products to which the woven fabric is pasted by the heating/pressing method.

11    laser displacement meter
12    test chip
13    fixing tool
21    pasted woven fabric
22    substrate (250 mm × 20 mm × t)
41    press plate
42    rod heater
43    die (upper)
44    die (lower)
45    polyester woven fabric
46    plastic plate (thickness: 2 mm, width: 50 mm, length: 100 mm)

## EP 2 481 556 A1

**Claims**

1. A casing for an electronic device comprising:

   a plastic substrate having a shape of a casing; and
   a knit/woven fabric pasted to the plastic substrate so as to cover an outermost surface of the substrate.

2. The casing for an electronic device according to claim 1, wherein
   the knit/woven fabric is made of at least one fiber selected from the group consisting of cotton, rayon, silk, wool, polyester fiber, and acrylic fiber.

3. The casing for an electronic device according to claim 1 or 2, wherein
   the plastic substrate is made of thermoplastic plastic.

4. The casing for an electronic device according to claim 3, wherein
   the thermoplastic plastic is at least one plastic selected from the group consisting of a polyolefin-based resin, styrene-based resin, saturated polyester-based resin, acrylic resin, polyamide resin, and vinyl chloride resin.

5. The casing according to claim 1, 2, 3 or 4, comprising an adhesive layer between the knit/woven fabric and the plastic substrate.

6. The casing for an electronic device according to claim 5, comprising a primer layer between the plastic substrate and the adhesive layer.

7. The casing for an electronic device according to claim 3, 4, 5 or 6, wherein
   the plastic substrate is an injection-molded product or extrusion-molded product.

8. A method for manufacturing a casing for an electronic device having improved impact resistance, vibration-damping property, surface resistivity, and weatherability, the method comprising the steps of:

   (A) molding a plastic substrate having a shape of a casing; and
   (B) pasting a knit/woven fabric to the plastic substrate so as to cover an outermost surface of the plastic substrate.

9. The method for manufacturing a casing for an electronic device according to claim 8, wherein
   the knit/woven fabric is made of at least one fiber selected from the group consisting of cotton, rayon, silk, wool, polyester fiber, and acrylic fiber.

10. The method for manufacturing a casing for an electronic device according to claim 8 or 9, wherein
    the plastic substrate is made of thermoplastic plastic.

11. The method for manufacturing a casing for an electronic device according to claim 10, wherein
    the thermoplastic plastic is at least one plastic selected from the group consisting of a polyolefin-based resin, styrene-based resin, polyester-based resin, acrylic resin, polyamide resin, and vinyl chloride resin.

12. The method for manufacturing a casing for an electronic device according to claim 8, 9, 10 or 11, wherein
    step (B) is performed by using an adhesive and an optional primer.

13. The method for manufacturing a casing for an electronic device according to claim 8, 9, 10, 11 or 12, wherein
    step (B) is performed by heating and pressing.

14. The method for manufacturing a casing for an electronic device according to claim 8, 9, 10, 11, 12 or 13, wherein
    step (A) is performed by injection molding or extrusion molding.

15. An electronic device comprising the casing for an electronic device according to any one of claims 1 to 7 or the casing for an electronic device manufactured by the method according to any one of claims 8 to 14.

# FIG. 1

# FIG. 2

# FIG. 3

# FIG. 4

**EUROPEAN SEARCH REPORT**

Application Number

EP 11 18 8733

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 544 418 A (HOLTZMAN SAMUEL J) 1 December 1970 (1970-12-01) | 1-5, 7-11, 13-15 | INV. B29C70/22 B29C70/78 |
| Y | * column 1, line 41 - column 2, line 65; claims 1,2,4,6; figures 1,9,10 * * column 6, lines 12-59 * * column 7, lines 10-57 * ----- | 6,12 | B29K105/08 B29K311/10 B29K267/00 B29K701/12 B29D99/00 G06F1/16 |
| Y | WO 93/23236 A1 (AMERICAN STANDARD INC [US]) 25 November 1993 (1993-11-25) * page 13, paragraphs 1,2 * * page 14, paragraph 2 * ----- | 6,12 | G06F1/18 |
| X | JP 2001 267775 A (OKI ELECTRIC IND CO LTD) 28 September 2001 (2001-09-28) | 15 | |
| A | * abstract * ----- | 1-14 | |
| A | EP 1 782 948 A1 (FUJITSU COMPONENT LTD [JP]) 9 May 2007 (2007-05-09) * paragraphs [0070], [0137], [0138]; claims 1,2; figure 4 * ----- | 1-15 | |
| | | | TECHNICAL FIELDS SEARCHED (IPC) |
| | | | B29C B29K B29D G06F |

The present search report has been drawn up for all claims

| Place of search | Date of completion of the search | Examiner |
|---|---|---|
| Munich | 23 May 2012 | Foulger, Caroline |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 2 481 556 A1**

## ANNEX TO THE EUROPEAN SEARCH REPORT
## ON EUROPEAN PATENT APPLICATION NO.

EP 11 18 8733

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2012

| Patent document cited in search report | | Publication date | Patent family member(s) | | Publication date |
|---|---|---|---|---|---|
| US 3544418 | A | 01-12-1970 | CH | 417870 A | 31-07-1966 |
| | | | CH | 423115 A | 31-10-1966 |
| | | | DE | 1529957 B1 | 08-06-1972 |
| | | | GB | 1067829 A | 03-05-1967 |
| | | | GB | 1067830 A | 03-05-1967 |
| | | | US | 3544418 A | 01-12-1970 |
| WO 9323236 | A1 | 25-11-1993 | AT | 159889 T | 15-11-1997 |
| | | | AU | 2692092 A | 13-12-1993 |
| | | | BR | 9207129 A | 19-11-1996 |
| | | | CA | 2118499 A1 | 25-11-1993 |
| | | | DE | 69223066 D1 | 11-12-1997 |
| | | | DE | 69223066 T2 | 10-06-1998 |
| | | | EP | 0647177 A1 | 12-04-1995 |
| | | | ES | 2110524 T3 | 16-02-1998 |
| | | | JP | 3283261 B2 | 20-05-2002 |
| | | | JP | H07506546 A | 20-07-1995 |
| | | | KR | 100246937 B1 | 15-03-2000 |
| | | | WO | 9323236 A1 | 25-11-1993 |
| JP 2001267775 | A | 28-09-2001 | NONE | | |
| EP 1782948 | A1 | 09-05-2007 | EP | 1782948 A1 | 09-05-2007 |
| | | | JP | 2007196659 A | 09-08-2007 |
| | | | US | 2007102110 A1 | 10-05-2007 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 57049534 A
- JP 4079820 B
- JP 6032350 B
- JP 10146907 A
- JP 10156927 A
- JP 2001071422 A
- JP 2001267775 A
- JP 2003092487 A
- JP 2005135425 A
- JP 2004128173 A
- JP 2006281726 A